# EUROPEAN PATENT SPECIFICATION

(11) **EP 0 728 789 B1**
(45) Date of publication and mention of the grant of the patent: **18.04.2001**
(21) Application number: 96200451.1
(22) Date of filing: 22.02.1996
(51) Int. Cl.: C08G 59/68, C08G 59/62

(54) **Process for making epoxy resin prepregs and laminates**
Verfahren zur Herstelllung von Prepregs und Schichtstoffen auf Epoxydharzbasis
Procédé pour la préparation de préimprégnés et de laminés à base de résine époxy

(30) Priority: 27.02.1995 JP 3827495; 29.03.1995 JP 7120795
(43) Date of publication of application: 28.08.1996
(73) Proprietor: MATSUSHITA ELECTRIC WORKS, LTD., Kadoma-shi Osaka 571 (JP)
(72) Inventor: Nakamura, Yoshihiko, Kadoma-shi, Osaka 571 (JP); Matsumura, Masahiro, Kadoma-shi, Osaka 571 (JP); Iwamoto, Narimasa, Kadoma-shi, Osaka 571 (JP); Motobe, Hidetsugu, Kadoma-shi, Osaka 571 (JP); Hatta, Yukio, Kadoma-shi, Osaka 571 (JP)
(74) Representative: Kupecz, Arpad

(56) References cited:
- GB-A- 1 260 896

## Description

This invention relates to a process for the preparation of an epoxy resin prepreg for use in printed wiring board, by impregnating a substrate with an epoxy resin composition, said epoxy resin composition comprising:
a) an epoxy resin;
b) a hardening agent which includes multifunctional phenols having more than two phenolic hydroxyl groups in each molecule; and
c) a hardening promotion agent, which is a compound represented by a following general formula (1) : 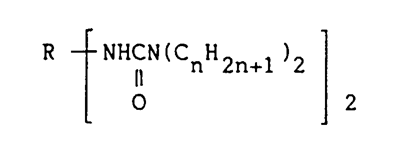
in which 'n' denotes an integer of 1-4, and R denotes an organic group of a valence of 2. The invention also relates to such a process for the preparation of a laminate of epoxy resin prepreg for use in printed wiring board, involving the use of an epoxy resin composition as mentioned above.

### DESCRIPTION OF RELATED ART

The laminated sheet used as the material for the printed wiring board has been manufactured by laminating prepregs of such substrate as a glass cloth or the like impregnated with a varnish consisting of an epoxy resin composition and dried, disposing copper foils on the top and bottom of the laminated prepregs, and molding them integral. In such epoxy resin composition for the purpose of making the prepreg and the laminated sheet as well, it has been general that such compound of amines as dicyandiamide is used as a hardening agent. In recent years, on the other hand, continued imcrements in mounting density of circuit elements are demanding a provision of a laminated sheet more excellent in the heat resistance than known laminated sheets, and a use of a phenolic hardening agent excellent in the heat resistance and effective in shortening required molding time and so on has been investigated. The present inventors have also investigated the epoxy resin compositions for use in making the laminated sheet with the phenolic hardening agent employed, and have discovered that, as has been disclosed in Japanese Patent Application No. 6-29982, a use of imidazoles, tertiary amines or the like as a hardening promotion agent causes a problem to arise in respect of the preservation stability of the prepreg, whereas a use of organic phosphine-containing compound, in particular, such organic phosphine·organic boron complex as tetraphenylphosphonium·tetraphenylborate as the hardening promotion agent improves remarkably the preservation stability of the prepreg.

However, the organic phosphine organic boron complex such as tetraphenylphosphonium·tetraphenylborate is generally incompatible or compatible (soluble) just in trace amount with the epoxy resin and solvents at normal temperatures, and varnishes (epoxy resin compositions) with these hardening promotion agents blended therein have been in opaque state in which the hardening promotion agent is dispersed. Due to this, there has been a problem that the varnish preserved for many hours (for about a week) is caused to become non-homogeneous by the precipitation of dispersed hardening promotion agent so as to render the prepreg to fluctuate in expected properties. In the multilayered printed circuit board, on the other hand, it is required to secure a sufficient adhesion between printed copper circuit formed in inner layered circuit board and a resin forming prepregs. The inner layered circuit board is usually prepared by forming a circuit pattern in electrolytic copper foil bonded on a surface of copper-clad laminate. Usual electrolytic copper foil is provided to be roughened on one surface, referred to as a matte surface, and smoothed on the other surface, referred to as a shiny surface, and the copper foil is bonded at the roughened matte surface onto a laminate in forming the copper clad laminate, so that the top surface of the printed copper circuit formed on the inner layered circuit board will be the smooth shiny surface and the adhesion between the copper circuit and the prepreg resin will tend to be lowered. For this reason, it has been demanded to elevate the adhesion between the copper circuit and the prepreg resin.

Accordingly, it has been attempted in various manners to elevate the adhesion between the copper circuit and the prepreg resin such that, for example, a copper oxide is formed on the surface of the copper circuit to elevate the adhesion, whereby the copper circuit is provided with fine projections inherent to the surface of the copper oxide obtained through an oxidizing treatment of copper, and the copper circuit surface is roughened by such fine projections to be able to elevate the adhesion. For a measure of forming the copper oxide on the surface of the copper circuit, one referred to as a blackening treatment employing an alkaline aqueous solution containing sodium chlorite has been generally employed.

While the adhesion between the copper circuit and the prepreg resin may be elevated by forming the copper oxide on the surface of the copper circuit, there has arisen such drawback as in the following. That is, as the copper oxide, in particular, cupric oxide is readily soluble in acid, an immersion in a bath of chemical or electrolytic plating solution of the multilayered substrate provided with through-holes for performing a through-hole plating causes cut and exposed copper oxide layere on inner walls of the through-holes of the copper circuit to melt in such acid as hydrochloric acid, so that such solvency erosion as a halo phenomenon will be readily caused to occur due to infiltration of the plating solution along boundaries between the copper circuit and the prepreg resin in the inner walls of the through-holes, and the reliability of the multilayered printed wiring board may have to be lowered.

British Patent GB-A 1.260.896 relates to an epoxy resin composition as mentioned in the preamble of claim 1, for use as a laminating resin. Said reference relates to obtaining a reduced curing time of the composition, as well as to obtaining an optimum in fusibility time. Examples in said reference show that using no solvent for the components yields better results retarding the infusibility time, if compared to when a solvent is used. This document does not refer to improving preservation stability and preventing the hardening promotion agent from precipitating.

A prior art related to the present invention is Japanese Patent Laid-Open Publication No. 5-163373 and, as reference art, U.S. Patent Nos. 4,953,603, 4,559,395, 4,604,317 and 5,262,491 are enumerated.

### SUMMARY OF THE INVENTION

The present invention has been suggested in view of the foregoing state of art, and its object is to provide an epoxy resin composition containing a phenolic hardening agent, which composition can manufacture a prepreg excellent in the preservation stability, and prevent the hardening promotion agent from precipitating even after the preservation for many hours in the form of varnish. It is a further object to obtain an epoxy resin composition which allowing the prepreg less causing the solvency erosion (halo phenomenon) due to the infiltration of the plating solution along the boundaries between the

copper circuit formed in the inner layered circuit board and the prepreg resin to the obtainable.

According to the present invention, the above object of manufacturing the prepreg excellent in preservation stability can be established by means of a process for the preparation of an epoxy resin prepreg as mentioned herein before, characterized in that said epoxy resin composition further comprises:
d) a first solvent for dissolving the hardening agent (b), and
e) a second solvent for dissolving the hardening promotion agent (c),
the epoxy resin (a) and respective hardening and hardening promotion agents (b, c) being compatible with each other in the presence of the first and second solvents (d, e).

A further object of obtaining a laminate for use in printed circuit board, is obtained by means of the process for the preparation of a laminate of epoxy resin prepregs as mentioned herein before, characterized in that said epoxy resin composition further comprises:
(d) a first solvent for dissolving the hardening agent (b), and
(e) a second solvent for dissolving the hardening promotion agent (c),
the epoxy resin (a) and respective hardening and hardening promotion agents (b, c) being compatible with each other in the presence of the first and second solvents (d, e).

Further objects and advantages of the present invention shall be clarified as the description of the invention advances in the followings with reference to preferred embodiments.

While the present invention shall now be detailed with reference to specific embodiments, it should be appreciated that the intention is not to limit the invention only to the embodiments but rather to include all alterations, modifications and equivalent arrangements possible within the scope of appended claims.

### DETAILED DESCRIPTION OF THE PREFERRED EMBODIMENTS

The epoxy resin employed in the present invention may be any compound having more than two epoxy groups in each molecule, and may even be a mixture. As typical ones of such resin, bisphenol A type epoxy resin, brominated bisphenol A type epoxy resin, bisphenol F type epoxy resin, cresol novolak type epoxy resin, trifunctional type epoxy resin and the like can be employed, but the use is not limited only to them.

For the phenolic hardening agent employed in the present invention, any compound having more than two phenolic hydroxyl groups in each molecule or even a mixture of such compounds may be used. Typical phenolic hardening agent will be phenol novolak, cresol novolak and the like, but the use may not be limited thereto.

The hardening promotion agent employed in the present invention is a compound represented by the foregoing general formula (1). Practical examples of such compound will be such compounds as shown by later described structural formula (7) or (8), respective which may be employed alone or in combination of two or more of them.

The solvent also employed in the present invention is one for dissolving the hardening promotion agent, practical examples of which will be such alcoholic solvents as methanol, methoxypropanol and so on, water and the like, while it is not required to be limited to them. Further, the particular solvent is employed concurrently with other solvent or solvents for dissolving the epoxy resin and hardening agent, examples of which other solvent will be such solvents of ketones as methyl ethyl ketone and so on.

While the epoxy resin composition for use in the laminated sheet according to the present invention contains as essential components the foregoing epoxy resin, hardening agent, hardening promotion agent and solvent, the composition may contain such further component or components as a phenoxy resin, filler additive or the like, as occasion demands, to an extent of not impairing the objects of the invention. Further, while the phenoxy resin is effective to render the melting viscosity of obtainable prepreg to be readily adjustable, an excess content thereof impairs the mechanical strength, in particular, bending strength of the laminated sheet, it is preferable that the phenoxy resin is used in a range of 3 to 10 parts by weight with respect to the sum 100 parts by weight of the epoxy resin and hardening agent.

Accordingly, the presence in the epoxy resin composition of the hardening agent represented by the general formula (1) is effective to allow the prepreg excellent in the preservation stability to be obtainable, and to prevent the hardening promotion agent from precipitating even when the varnish is preserved for many hours because of a high solubility in the solvent.

Further in the present invention, it is optimum to have dicyandiamide also contained in the composition, at a content set to be 0.1 to 1.0 parts by weight with respect to the sum 100 parts by weight of the epoxy resin and phenolic hardening agent, so as to be able to more effectively reduce the halo phenomenon. With the content of dicyandiamide less than 0.1 parts by weight renders the effect insufficient, while a content more than 1.0 parts by weight causes the rate of moisture absorption of obtainable hardened resin increased, tending to have the moisture-absorbing, heat resistance and electric characteristics of the resultant multilayered printed wiring board to be deteriorated.

As a solvent, methoxypropanol as well as methyl ethyl ketone for dissolving the epoxy resin, hardening agent and phenoxy resin are used at a desired rate.

In this case, the phenoxy resin is dissolved in methyl ethyl ketone to be an initial solution, and then the epoxy resin and hardening agent are mixed and dissolved in this initial solution to be an intermediate solution. Next, a mixture of methoxypropanol as the solvent with a hardening promotion agent is added to the intermediate solution of methyl ethyl ketone and they are mixed to prepare an epoxy resin composition (varnish).

A glass cloth (a product by a Japanese manufacturer ASAHI SWIVEL, Article #7628W) was impregnated with the epoxy resin composition (varnish) prepared as in the above, they were dried at 150°C, and a prepreg of a resin content of about 45% by weight and a thickness of about 0.2mm was thereby prepared. Drying time in this event was set for every epoxy resin composition so that the melting viscosity at 130°C (the lowest melting viscosity when measured at 130°C) of resin component at a stage when the prepreg is attained will be in a range of 300 to 500 poise. With respect to this epoxy resin composition (varnish) thus obtained, the transparency of the varnish right after being prepared and occurrence of sediments in the varnish after 7 days preservation were evaluated, and also the preservation stability of the prepreg thus obtained was evaluated, the result of which was as shown in a following table.

Concrete testing process for respective items of the evaluation has been as in the followings.

### Transparency of Varnish Right After Being Prepared:

Appearances of the epoxy resin composition (varnish) right after being prepared were evaluated with visual observation and discriminated whether transparent or opaque.

### Occurrence Of Sediments In Varnish Preserved For 7 Days:

After preservation for seven days of the epoxy resin composition (varnish) in an atmosphere of 25°C, the occurrence of sediments in the varnish was evaluated with visual observation and discriminated whether present or absent.

### Preservation Stability of Prepreg:

The prepreg was preserved in an isothermic bath at 40°C, the melting viscosity at a temperature of 130°C was measured at every fixed time intervals to investigate its variation with time, and the number of days for which the rate of change from an initial value was below 50% (except the day on which the rate exceeded 50%) was regarded as the number of days preservable at 40°C. The melting viscosity was measured by means of a downward-movement type flowmeter with respect to a resin component adhering to but removed as crumpled from the prepreg [ Rate of change in melting viscosity (%) = (melting viscosity after time elapsed - initial melting viscosity) x 100 / (initial melting viscosity)].

### Measuring Manner for Glass Transition Temperature:

A laminate obtained by stacking three prepregs obtained and molding the stack as held between metal plates through release films under conditions of a pressure 40Kg/cm² and a temperature of 170°C for 90 minutes was employed as a test member, thermal dispersion in dynamic viscoelastic properties of which was measured, and a peak temperature of tan δ obtained was regarded as the glass transition temperature.

### Measuring Manner for "Halo" Characteristics:

An inner-layered circuit board was prepared with use of a copper-clad laminate of glass cloth substrate (a product by MATSUSHITA ELECTRIC WORKS, Article No. 1766) of 0.7mm thick and having copper foils of 70mm thick on both sides of the laminate, the foils being bonded on their roughened (matte) surface side to the laminate, and this inner-layered circuit board was then dipped for 2 minutes in an aqueous solution of sodium chlorite and adjusted at 95°C, to have exposed surfaces of the copper circuit on the inner-layered circuit board subjected to an oxidation treatment. Then, the inner-layered circuit board was rinsed and dried. Thereafter, three prepregs were stacked on each of the top and bottom of the circuit board, copper foils of 18µm were further stacked on its outer sides, the stack thus obtained was held between metal plates and was molded under such conditions as a pressure of 40Kg/cm² and a temperature of 170°C for 90 minutes, and a multilayered substrate was obtained. Then, this multilayered substrate was subjected to a through-hole working with a drill bit of 0.4mm⌀, under the conditions of a rotating speed of 80,000rpm and a feeding rate of 1.6m/min., and the thus obtained substrate having through-holes was used as a test member. The test member was immersed for 60 minutes in an aqueous solution of hydrochloric acid of 17.5%, the copper foils of 18µm on the surfaces were removed through an etching, thereafter a state of "halo" occurrence was observed by a microscope of 100x magnification, and an extent of halo (infiltrating size of the solution from the wall surface of the through-hole) was measured, which measurement was used as a numerical value denoting the "halo" characteristics.

### Measuring Manner for The Rate of Moisture Absortion:

A laminate obtained by stacking eight prepregs into a stack and Molding this stack as held between the metal plates through releasing films and under the conditions of a pressure of 40Kg/cm² and a temperature of 170°C for 90 minutes was used as a testing member, which was subjected to a moisture absorbing treatment for seven days in a constant temperature and constant moisture bath of 85°C and 85%. Weight of the testing member before and after the moisture absorbing treatment was measured, and the rate of moisture absorption was calculated.

### Examples 1-3 & Comparative Examples 1-3:

Examples 1-3 and Comparative Examples 1-3 were executed under the conditions of the following Table, and such results as shown in an item of evaluation were obtained by the various testing manners as in the above.
As the respective components, such materials as follows were employed:
(a) Epoxy resin:
   - Epoxy resin 1 -: ESB400 (Pruduct by Japanese firm SUMITOMO KAGAKU) tetrabromobisphenol A type epoxy resin (epoxy equivalent weight = EEW = 400)
   - Epoxy resin 2 -: DER511 (Product by U.S. firm DAW CHEMICAL) brominated bisphenol A type epoxy resin (epoxy equivalent weight = EEW = 500)
   - Epoxy resin 3 -: YDCN702P (Product by Japanese firm TOHTO KASEI) multifunctional (mainly more than trifunctional) cresol novolak type epoxy resin (epoxy equivalent weight = EEW = 200)
(b) Hardening agent:
   - Phenol novolaks -: TAMANORL 752 (Product by Japanese firm ARAKAWA KAGAKU) phenol novolak (hydroxyl group equivalent weight = about 105)
   - Phenoxy resin -: PKHH (Product by UNION CARBIDE) Average molecular weight by GPC:Mw = 42600, Mn = 11200
(c) Hardening promotion agent:
   Hardening promotion agent 1 - Following compound of a melting point about 200°C 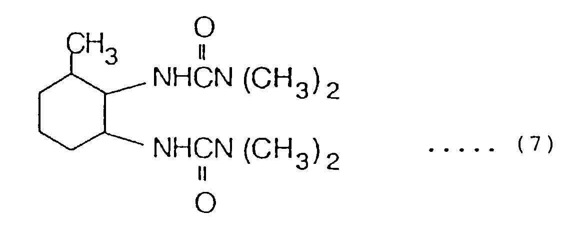
   Hardening promotion agent 2 - Following compound of a melting point about 190°C 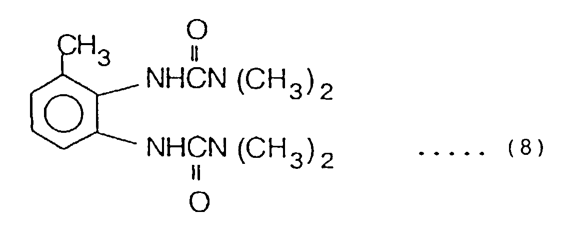
   Hardening promotion agent 3 - Tetraphenylphosphoniumtetraphenyborate
   Hardening promotion agent 4 - 2-ethyl 4-methyl imidazole (2E4MZ)
(d) Solvent:
   - Solvent 1 -: Methyl ethyl ketone
   - Solvent 2 -: Methoxypropanol

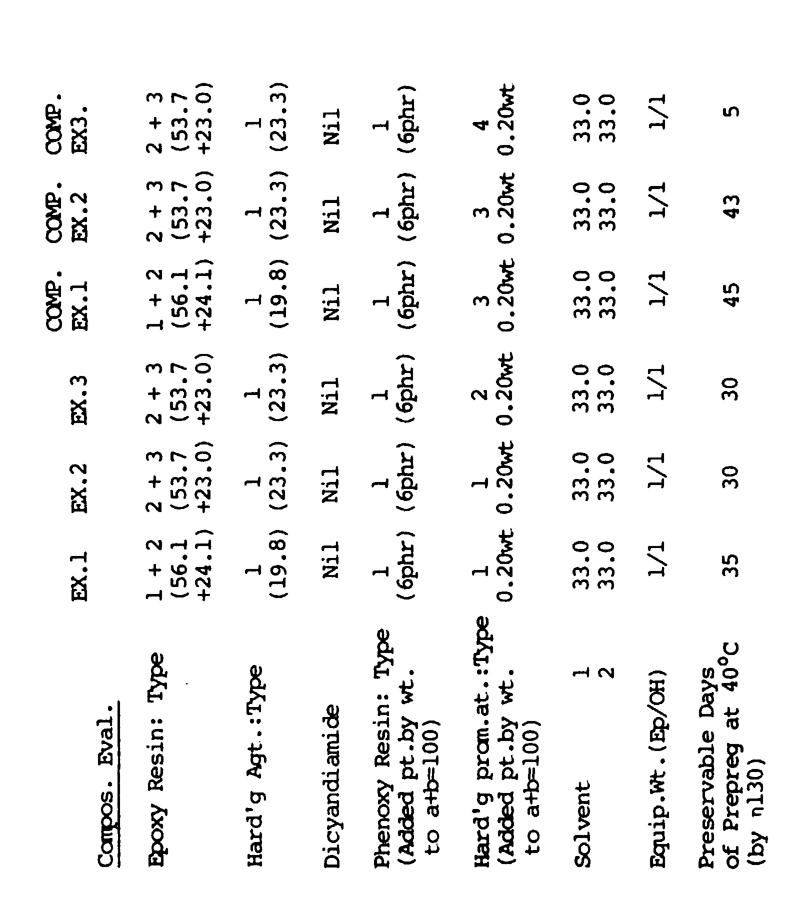

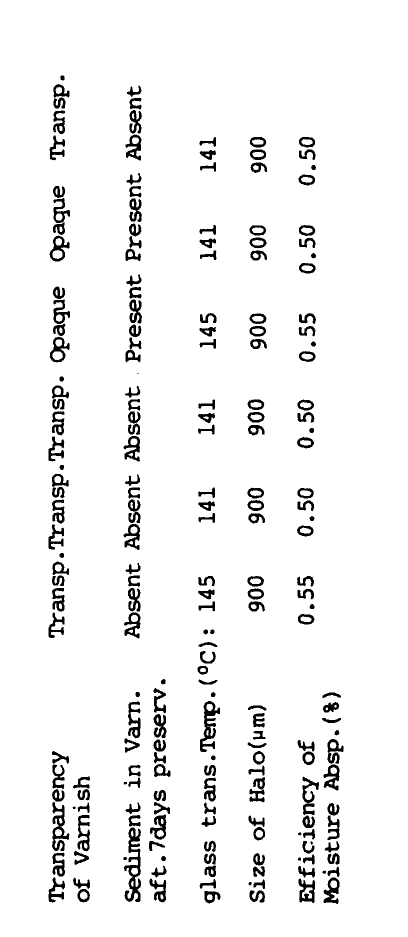

While in the foregoing Examples and Comparative Examples there have been shown examples of the components, the composition according to the present invention are not limited to these examples but various other materials and other compounds can be employed.

## Claims

1. A process for the preparation of an epoxy resin prepreg for use in printed wiring board, by impregnating a substrate with an epoxy resin composition, said epoxy resin composition comprising:
a) an epoxy resin;
b) a hardening agent which includes multifunctional phenols having more than two phenolic hydroxyl groups in each molecule; and
c) a hardening promotion agent, which is a compound represented by a following general formula (1): 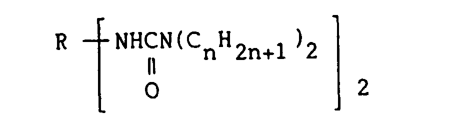 in which 'n' denotes an integer of 1-4, and R denotes an organic group of a valence of 2, **characterized** in that said epoxy resin composition further comprises:
(d) a first solvent for dissolving the hardening agent (b), and
(e) a second solvent for dissolving the hardening promotion agent (c),
the epoxy resin (a) and respective hardening and hardening promotion agents (b, c) being compatible with each other in the presence of the first and second solvents (d, e).

2. A process according to claim 1, **characterized** in that the hardening promotion agent (c) is a compound represented by a following structural formula:

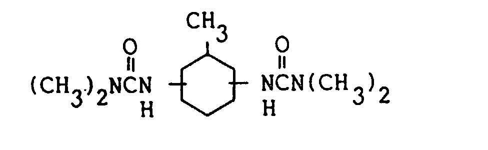

3. A process according to claim 1, **characterized** in that the hardening promotion agent (c) is a compound represented by a following structural formula:

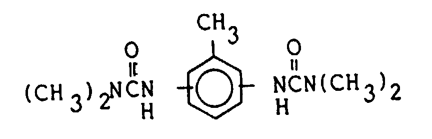

4. A process according to claim 2, **characterized** in that the epoxy resin composition further consists of dicyandiamide in a content of 0.1 to 1.0 part by weight of the sum 100 parts by weight of the epoxy resin (a) and phenolic hardening agent (b).

5. A process according to claim 3, **characterized** in that the epoxy resin composition further consists of dicyandiamide in a content of 0.1 to 1.0 part by weight of the sum 100 parts by weight of the epoxy resin (a) and phenolic hardening agent (b).

6. A process for the preparation of a laminate of epoxy resin prepregs for use in printed wiring board, involving the use of an epoxy resin composition comprising:
a) an epoxy resin;
b) a hardening agent which includes multifunctional phenols having more than two phenolic hydroxyl groups in each molecule; and
c) a hardening promotion agent, which is a compound represented by a following general formula (1): 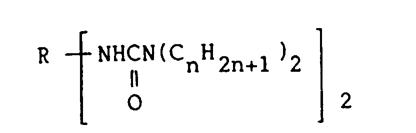 in which "n" denotes an integer of 1-4, and R denotes an organic group of a valence of 2, **characterized** in that said epoxy resin composition further comprises:
(d) a first solvent for dissolving the hardening agent (b), and
(e) a second solvent for dissolving the hardening promotion agent (c),
the epoxy resin (a) and respective hardening and hardening promotion agents (b, c) being compatible with each other in the presence of the first and the second solvents (d, e).

7. A process according to claim 6, **characterized** in that the hardening promotion agent (c) is a compound represented by a following structural formula:

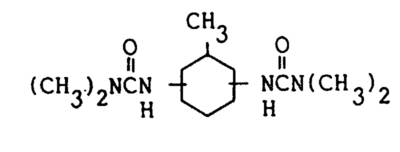

8. A process according to claim 6, **characterized** in that the hardening promotion agent (c) is a compound represented by a following structural formula:

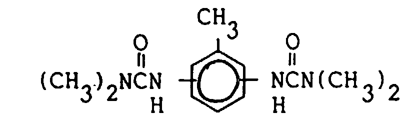

9. A process according to claim 7, **characterized** in that the epoxy resin composition further consists of dicyandiamide in a content of 0.1 to 1.0 part by weight of the sum 100 parts by weight of the epoxy resin (a) and phenolic hardening agent (b).

10. A process according to claim 8, **characterized** in that the epoxy resin composition further consists of dicyandiamide in a content of 0.1 to 1.0 part by weight of the sum 100 parts by weight of the epoxy resin (a) and phenolic hardening agent (b).

11. A process according to claim 1 or 6, **characterized** in that the first solvent (d) is one selected from solvents of ketones including methyl ethyl ketone, and the second solvent (e) is one selected from the group consisting of alcoholic solvents including methanol and methoxypropanol, and water.

## Patentansprüche

1. Verfahren zur Herstellung eines Epoxidharz-Prepregs zur Verwendung bei Platinen durch Imprägnieren eines Substrates mit einer Epoxidharz-Zusammensetzung, wobei die Epoxidharz-Zusammensetzung umfasst:
a) ein Epoxidharz;
b) ein Härtungsmittel, das multifunktionelle Phenole mit mehr als zwei phenolischen Hydroxylgruppen in jedem Molekül umfasst; und
c) ein Härtungsförderer, der eine durch die nachstehende allgemeine Formel (1) dargestellte Verbindung ist: 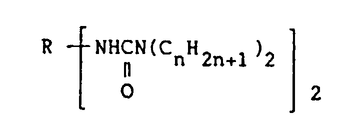 wobei 'n' eine ganze Zahl von 1 - 4 bezeichnet, und R für einen organischen Rest der Wertigkeit 2 steht, dadurch gekennzeichnet, dass die Epoxidharz-Zusammensetzung weiterhin:
(d) ein erstes Lösungsmittel zum Lösen des Härtungsmittels (b), und
(e) ein zweites Lösungsmittel zum Lösen des Härtungsförderers (c) umfasst, wobei das Epoxidharz (a) und das jeweilige Härtungs- und Härtungsförderungsmittel (b, c) in Gegenwart des ersten und zweiten Lösungsmittels (d, e) miteinander kompatibel sind.

2. Verfahren nach Anspruch 1, dadurch gekennzeichnet, dass der Härtungsförderer (c) eine durch die nachstehende Strukturformel dargestellte Verbindung ist:

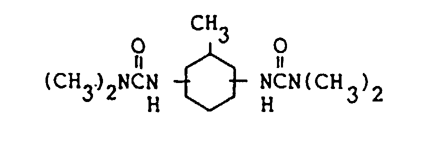

3. Verfahren nach Anspruch 1, dadurch gekennzeichnet, dass der Härtungsförderer (c) eine durch die nachstehende Strukturformel dargestellte Verbindung ist:

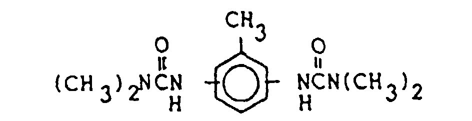

4. Verfahren nach Anspruch 2, dadurch gekennzeichnet, dass die Epoxidharz-Zusammensetzung zudem 0,1 bis 1,0 Gew.-Teile Dicyanamid, bezogen auf 100 Gew.-Teile der Summe aus Epoxidharz (a) und phenolischem Härtungsmittel (b), enthält.

5. Verfahren nach Anspruch 3, dadurch gekennzeichnet, dass die Epoxidharz-Zusammensetzung zudem 0,1 bis 1,0 Gew.-Teile Dicyanamid, bezogen auf 100 Gew.-Teile der Summe aus Epoxidharz (a) und phenolischem Härtungsmittel (b), enthält.

6. Verfahren zur Herstellung eines Laminates aus Epoxidharz-Prepregs zur Verwendung bei Platinen, umfassend die Verwendung einer Epoxidharz-Zusammensetzung, welche:
a) ein Epoxidharz;
b) ein Härtungsmittel, das multifunktionelle Phenole mit mehr als zwei phenolischen Hydroxylgruppen in jedem Molekül umfasst; und
c) einen Härtungsförderer umfasst, der eine durch die nachstehende allgemeine Formel (1) dargestellte Verbindung ist: 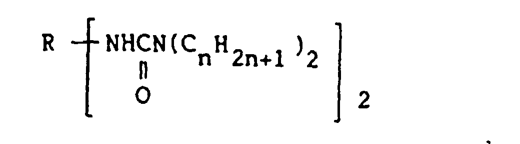 wobei "n" eine ganze Zahl von 1 - 4 bezeichnet, und R für einen organischen Rest der Wertigkeit 2 steht, dadurch gekennzeichnet, dass die Epoxidharz-Zusammensetzung weiterhin:
(d) ein erstes Lösungsmittel zum Lösen des Härtungsmittels (b), und
(e) ein zweites Lösungsmittel zum Lösen des Härtungsförderers (c) umfasst, wobei das Epoxidharz (a) und das jeweilige Härtungs- und Härtungsförderungsmittel (b, c) in Gegenwart des ersten und zweiten Lösungsmittels (d, e) miteinander kompatibel sind.

7. Verfahren nach Anspruch 6, dadurch gekennzeichnet, dass der Härtungsförderer (c) eine durch die nachstehende Strukturformel dargestellte Verbindung ist:

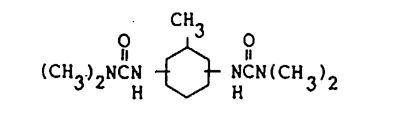

8. Verfahren nach Anspruch 6, dadurch gekennzeichnet, dass der Härtungsförderer (c) eine durch die nachstehende Strukturformel dargestellte Verbindung ist:

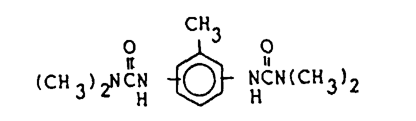

9. Verfahren nach Anspruch 7, dadurch gekennzeichnet, dass die Epoxidharz-Zusammensetzung zudem 0,1 bis 1,0 Gew.-Teile Dicyanamid, bezogen auf 100 Gew.-Teile der Summe aus Epoxidharz (a) und phenolischem Härtungsmittel (b), enthält.

10. Verfahren nach Anspruch 8, dadurch gekennzeichnet, dass die Epoxidharz-Zusammensetzung zudem 0,1 bis 1,0 Gew.-Teile Dicyanamid, bezogen auf 100 Gew.-Teile der Summe aus Epoxidharz (a) und phenolischem Härtungsmittel (b), enthält.

11. Verfahren nach Anspruch 1 oder 6, dadurch gekennzeichnet, dass das erste Lösungsmittel (d) aus Ketonen, einschließlich Methylethylketon, ausgewählt ist und das zweite Lösungsmittel (e) aus der Gruppe, bestehend aus alkoholischen Lösungsmitteln, einschließlich Methanol und Methoxypropanol, und Wasser, ausgewählt ist.

## Revendications

1. Procédé de préparation d'un préimprégné, à base de résine époxy, destiné à une utilisation dans un circuit imprimé, par imprégnation d'un substrat avec une composition à base de résine époxy, ladite composition à base de résine, comprenant :
(a) une résine époxy ;
(b) un agent de durcissement comprenant des phénols polyfonctionnels comportant au moins deux groupes hydroxyle phénoliques dans chaque molécule ; et
(c) un agent favorisant le durcissement, qui est un composé représenté par la formule générale (1) suivante : 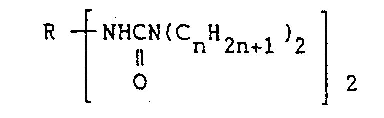 dans laquelle n représente un entier allant de 1 à 4, et R représente un groupement organique ayant une valence de 2, caractérisé en ce que ladite composition à base de résine époxy comprend en outre:
(d) un premier solvant pour dissoudre l'agent durcisseur (b), et
(e) un second solvant pour dissoudre l'agent favorisant le durcissement (c),
la résine époxy (a) et les agents de durcissement et favorisant le durcissement (b, c) respectifs, étant compatibles entre eux en présence des premier et second solvants (d, e).

2. Procédé selon la revendication 1, caractérisé en ce que l'agent favorisant le durcissement (c) est un composé représenté par la formule développée suivante :

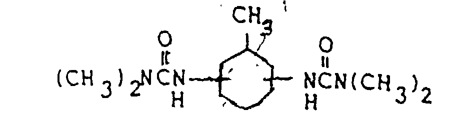

3. Procédé selon la revendication 1, caractérisé en ce que l'agent favorisant le durcissement (c) est un composé représenté par la formule développée suivante :

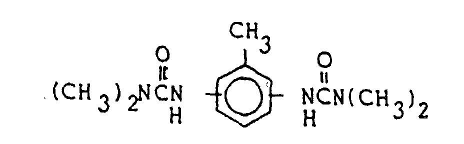

4. Procédé selon la revendication 2, caractérisé en ce que la composition à base de résine époxy comprend en outre du dicyandiamide selon une teneur de 0,1 à 1,0 partie en poids pour 100 parties en poids de la résine époxy (a) et de l'agent de durcissement phénolique (b).

5. Procédé selon la revendication 3, caractérisé en ce que la composition à base de résine époxy comprend en outre du dicyandiamide selon une teneur de 0,1 à 1,0 partie en poids pour 100 parties en poids de la résine époxy (a) et de l'agent de durcissement phénolique (b).

6. Procédé de préparation d'un stratifié de préimprégnés à base de résine époxy pour une utilisation dans une plaque à câblage imprimé, comprenant l'utilisation d'une composition à base de résine époxy, comprenant :
(a) une résine époxy ;
(b) un agent de durcissement comprenant des phénols polyfonctionnels comportant au moins deux groupes hydroxyle phénoliques dans chaque molécule ; et
(c) un agent favorisant le durcissement consistant en un composé représenté par la formule générale (1) suivante : 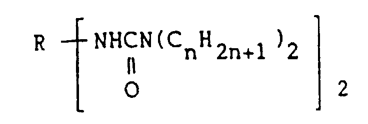 dans laquelle n représente un entier de 1 à 4, et R représente un groupe organique ayant une valence de 2, caractérisé en ce que ladite composition à base de résine époxy comprend en outre :
(d) un premier solvant pour dissoudre l'agent durcisseur (b), et
(e) un second solvant pour dissoudre l'agent favorisant le durcissement (c),
la résine époxy (a) et les agents de durcissement et favorisant le durcissement (b, c) respectifs, étant compatibles entre eux en présence des premier et second solvants (d, e).

7. Procédé selon la revendication 6, caractérisé en ce que l'agent favorisant le durcissement (c) est un composé représenté par la formule développée suivante :

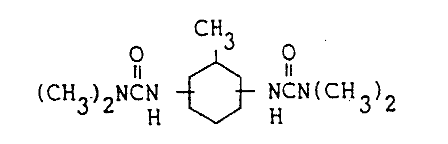

8. Procédé selon la revendication 6, caractérisé en ce que l'agent favorisant le durcissement (c) est un composé représenté par la formule développée suivante :

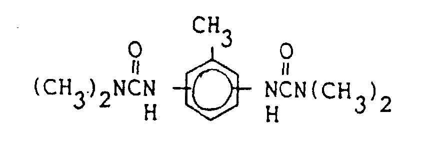

9. Procédé selon la revendication 7, caractérisé en ce que la composition à base de résine époxy comprend en outre du dicyandiamide selon une teneur de 0,1 à 1,0 partie en poids pour 100 parties en poids de la résine époxy (a) et de l'agent de durcissement phénolique (b).

10. Procédé selon la revendication 8, caractérisé en ce que la composition à base de résine époxy comprend en outre du dicyandiamide selon une teneur de 0,1 à 1,0 partie en poids pour 100 parties en poids de la résine époxy (a) et de l'agent de durcissement phénolique (b).

11. Procédé selon la revendication 1 ou 6, caractérisé en ce que le premier solvant (d) est choisi parmi les solvants cétoniques comprenant la méthyl éthyl cétone, et le deuxième solvant (e) est choisi parmi les solvants alcooliques comprenant le méthanol et le méthoxypropanol, et l'eau.
